# EUROPEAN PATENT SPECIFICATION

(11) **EP 1 164 700 B1**
(45) Date of publication and mention of the grant of the patent: **04.12.2002**
(21) Application number: 01108250.0
(22) Date of filing: 31.03.2001
(51) Int. Cl.: H03L 7/00, G01R 31/3193

(54) **Data flow synchronization**
Synchronisation eines Datenstromes
Synchronisation d'un flux de données

(43) Date of publication of application: 19.12.2001
(73) Proprietor: Agilent Technologies, Inc. (a Delaware corporation), Palo Alto, CA 94303 (US)
(72) Inventor: Behrens, Klaus-Peter, 71116 Gärtringen (DE); Rottacker, Markus, 70180 Stuttgart (DE); Mohr, Jörg-Walter, 72184 Eutingen (DE)
(74) Representative: Barth, Daniel

(56) References cited:
- US-A- 4 893 072
- US-A- 5 323 426
- US-A- 5 867 672
- US-A- 6 055 285

## Description

### BACKGROUND OF THE INVENTION

The present invention relates to synchronizing a data flow between devices.

For testing digital circuits, a device under test (DUT) typically receives a stimulus signal, and a response signal of the DUT on the stimulus signal is determined and e.g. compared with an expected response signal. Thus, errors can be determined e.g. when the determined response signals deviates from the expected response signal. Such apparatus for testing integrated circuit devices is known e.g. from US-A-4,893,072.

Such testing, however, requires that it is sufficiently clear when the actual response signal will appear, so that only such signals will be compared that actually correspond to each other. Otherwise, the test will most probably detect an error.

### SUMMARY OF THE INVENTION

It is an object of the present invention to reduce errors occurring due to a mismatch between actual and expected response signals to be compared within a testing system. The object is solved by the independent claims. Preferred embodiments are shown by the dependent claims.

According to the invention, a testing unit for testing e.g. a digital circuit as device under test (DUT) comprises a signal generator for applying a stimulus signal to the DUT. A synchronizing unit is coupled between an output of the DUT and a receiving unit of the testing unit. The testing unit might further provide an analyzing unit for comparing the received response signal from the DUT with an expected response signal.

The response signal from the DUT is applied to the synchronizing unit using a DUT clock rate as provided by the DUT. The synchronizing unit buffers the response signal applied from the OUT or, in other words, provides a certain delay time to the response signal. The receiving unit reads out the buffered response signal from the synchronizing unit, however, using a clock rate as provided by the testing unit for reading out. Thus, the delay time provided by the synchronizing unit depends on an initial delay time and the history of mismatch between DUT and testing unit characteristics or, in other words, the difference between the application of data to and the reading out from the synchronizing unit.

Hence, the invention allows balancing variations between the clock rates of the DUT and the testing unit Such variations can be caused e.g. due to cumulative phase error in source synchronous clocks or due to variations of the phases of the different clocks. Further reasons can be that a DUT data protocol allows such variations because a data valid signal alarm is always provided.

For balancing such clock rates variations, synchronization circuits as disclosed e.g. in US-A-6,055,285, US-A-5,323,426,or US-A-5,867,672 can be applied accordingly.

In a preferred embodiment, the synchronizing unit comprises a structure with a plurality of registers. This structure might be a FIFO (first in first out) structure as well known in the art. A write pointer can be moved between the individual registers and defines which one of the pluralities of registers will receive a respective data word provided by the response signal from the DUT. Correspondingly, a read pointer can also be moved between the respective registers and defines which one of the registers the receiving unit can read out. While the write pointer will be clocked using the DUT clock for successively writing successive data words from the response signals to different registers, the read pointer will be clocked using the clock of the testing unit for successively reading out successive data words of the response signal buffered in the synchronizing unit.

Preferably, the synchronizing unit further comprises a latch controlled by the DUT clock, so that successive data words of the response signal will be latched with the DUT clock and thus successively written into successive registers.

In a further preferred embodiment, the initial delay time between a first (valid) write access from the DUT and a first (valid) read access by the receiving unit onto that written data word is provided dependent on the maximum expected variation between such write and read accesses. In the example of a synchronizing unit with a set of registers, the delay time can be determined by the number of registers between corresponding write and read accesses. Preferably, the initial delay time is set as half of the number of registers. In an example of a structure with eight registers, the initial delay time is preferably set to four registers. It is clear that the maximum delay time of the synchronizing unit has to be adjusted to cover all expected variations as e.g. known from prior tests or as specified for the DUT.

In another preferred embodiment, an initialization process is provided to initialize a first valid write access and/or a first valid read access. This can be accomplished e.g. by utilizing known reference signals having a known timing characteristics. So far there are two basic types:
1. Somewhere in the beginning of the DUT response data stream, the time of the response is known in data stream with an accuracy better than the duration of one clock of the testing unit. In this case the testing unit can determine the start position and time of the read and the write pointer.
2. The DUT provides a signal that indicates where to start. In this case the DUT will control the start of the write pointer and the testing unit will determine the start of the read pointer. For this the accuracy of the knowledge about the response time can be several clocks, but certainly not more than registers are there. In other words the amount of registers has to be more than the uncertainty range of the DUT response.

The invention can be partly or entirely embodied or supported by one or more suitable software programs, which can be stored on or otherwise provided by any kind of data carrier, and which might be executed in or by any suitable data processing unit. In particular, software tools can be used in conjunction with user test programs, or as system software to enable the synchronization feature.

### BRIEF DESCRIPTION OF THE DRAWINGS

Other objects and many of the attendant advantages of the present invention will be readily appreciated and become better understood by reference to the following detailed description when considering in connection with the accompanied drawing.

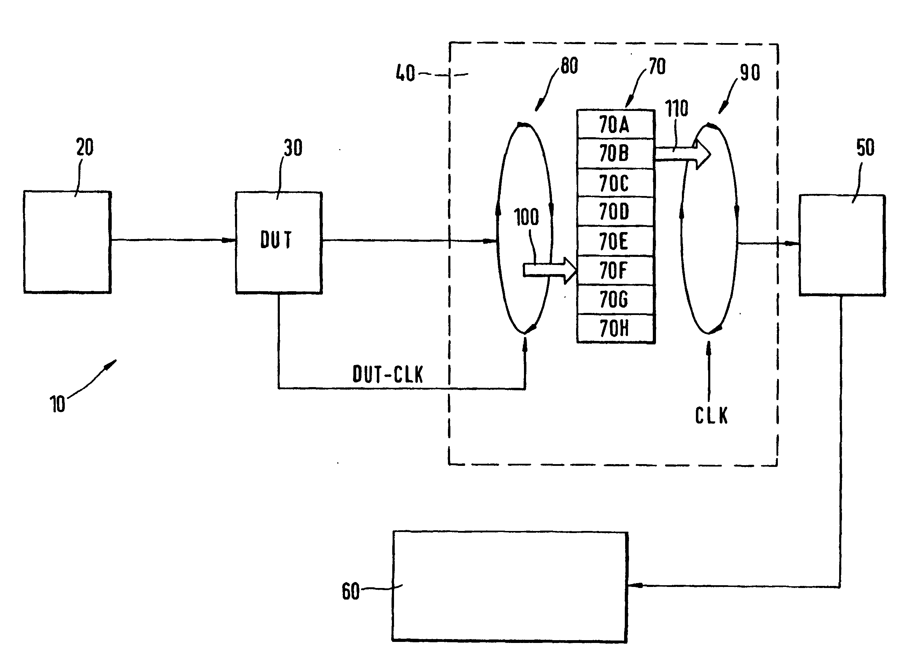

- Figure 1: shows a preferred test structure for a testing unit 10 according to the present invention.

### DETAILED DESCRIPTION OF THE INVENTION

In Fig. 1, a signal generator 20 provides a stimulus signal to a device under test DUT 30. A signal response of the DUT 30 on the stimulus signal is provided via a synchronizing unit 40 to a receiving unit 50. An analyzing unit 60 compares the response signal as received by the receiving unit 50 with an expected response signal for determining whether the DUT 30 behaves in the expected way or whether errors occur. Dependent on the application, the analyzing unit 60 might control the signal generator 20 and/or the stimulus signal as provided by the signal generator 20 or receive this stimulus signal.

It is clear that while the testing unit 10 comprises the signal generator 20, the synchronizing unit 40, the receiving unit 50, and the analyzing unit 60, the DUT 30 is not part thereof.

The synchronizing unit 40 further receives a clock signal DUT-CLK from the DUT 30 and a clock signal CLK of the testing unit 10. The clock signal DUT-CLK might be the internal clock signal of the DUT 30 or derived therefrom.

Accordingly, the clock signal CLK might be the internal clock signal of the testing unit 10 or derived therefrom.

The synchronizing unit 40 provides synchronization between the provision of the response signal from the DUT 30 and the receiving of the corresponding response signal by the receiving unit 50. Thus, it can be ensured that a certain event within the response signal from the DUT 30 can be unambiguously assigned to a corresponding event in the expected response signal, so that temporal mismatches between the actual and the expected response signal can be avoided, and that only corresponding events within the actual and expected response signal will be compared by that analyzing unit 60.

In the preferred embodiment of Figure 1, the synchronizing unit 40 comprises a delay unit 70 having a structure with a plurality of individual registers 70A, 70B,.... In the specific example of Figure 1, the delay unit 70 comprises eight registers 70A - 70H. A write unit 80 receives the response signal from the DUT 30 and successively writes successive data words of the response signal into successive registers of the delay unit 70. Accordingly, a read unit 90 successively reads out successive data words of the response signal as stored in the delay unit 70 and provides those data words to the receiving unit 50.

Not shown in Figure 1, the write unit 80 might comprise a latching unit controlled by the dock DUT-CLK for covering the timing variations less than the duration time of one clock.

Since the number of registers in the delay unit 70 is naturally limited, the delay unit 70 in conjunction with the write unit 80 and the read unit 90 preferably provides a FIFO structure, wherein the individual registers of the delay unit 70 are repeatedly written and read out e.g. in a circular manner as indicated in Figure 1. For that purpose, a write pointer 100 of the write unit 80 is repeatedly moved between the registers 70A - 70H, so that the registers of the delay unit 70 will be rewritten with each writing cycle. Accordingly, a read pointer 110 is moved repeatedly between the registers 70A-70H.

It is clear that the write accesses as provided by the write pointer 100 have to stay within limits in relation to the read accesses as provided by the read pointer 110, so that it is, on one hand, avoided that the write unit 80 will overwrite data in the delay unit 70 before it has been read out by the read unit 90, and, on the other hand, that it is avoided that the read unit 90 reads faster than the write unit 80 can write, so that the read unit 90 will virtually "overtake" the write unit 80. For that purpose, the clock rates DUT-CLK and CLK should be synchronized to a certain extend. Further, the number of registers 70i, with i = A, B, ..., of the delay unit 70, should be adapted to the maximum expected valid difference between corresponding read and write accesses.

In the example of Figure 1 the rates of the docks DUT-CLK and CLK are set to be equal, so that the synchronizing unit 40 only needs to balance phase mismatches between the clocks DUT-CLK and CLK. Further in the specific example of Figure 1, an initial delay time between corresponding read and write accesses will be set to half of the number of registers in the delay unit 70. In the example of Figure 1, the initial delay time will be set to four registers. That means that while the write unit 80 e.g. writes to register 70F, the read unit 90 initially reads out register 70B.

As shown in Figure 1, the write unit 80 will be clocked with the clock DUT-CLK as provided from the DUT 30, so that the write pointer 100 will be moved to the successive register with each successive clock cycle of the clock signal DUT-CLK. The read pointer 100, however, will be moved to a successive register with each successive cycle of the clock signal CLK as of the testing unit 10. That means that once the initial delay time has been set, deviations between the clocks DUT-CLK and CLK will also lead to deviations between corresponding read and write accesses for the same data word. In an example with an initial delay time of "four registers" in an eight registers structure, the number of registers between corresponding read and write accesses might decreased to 3, 2 or only 1 register or increase to 5, 6 or maximum 7 registers. However, as long as the minimum and maximum differences between corresponding read and write accesses are not exceeded, such deviations will be balanced by the synchronizing unit 40, so that the data integrity of the actual response signal with respect to the expected response signal can be preserved.

For initializing the synchronizing unit 40, both pointers 100 and 110 are preferably set in a reset mode e.g. pointing to register 70A, while the clocks DUT-CLK and CLK are turned off (or disabled) within the synchronizing unit 40. Thus, all coming data is ignored during the reset mode. With a valid signal "write start" it is indicated that the response signals from the DUT are valid now. With the write start signal, the dock DUT-CLK for the write unit 80 will be opened (or enabled) again, and data will be written successively with each cycle of the clock DUT-CLK into the registers 70A - 70H repeatedly. With a valid signal "read start" it is indicated that the read unit 90 shall now be enabled to read out data from the delay unit 70. The dock signal CLK of the testing unit 10 will be opened again for the read unit 90, and data will be read out from the registers 70A-70H successively with each cycle of the dock CLK. The temporal difference between the appearance of the valid signals 'read start' and 'write start' represents the initial delay time.

Further possible variations of implementation for the initializations are:
1. The amount of registers is increased to compensate some propagation delay in the system as well. After reset the read and write pointers are clocked together with DUT-CLK, but the read pointer is always running some registers behind. With the write start event the read pointer will halt. With the read start event the read pointer will be clocked by the clock of the testing unit.
2. With no initial difference, the previous implementation variant would be compatible with very first described.

## Claims

1. A testing unit (10) for testing a device under test - DUT - (30), comprising:
a signal generator (20) adapted for applying a stimulus signal to the DUT (30),
a receiving unit (50) adapted for receiving a response signal from the DUT on the applied stimulus signal, and
a synchronizing unit (40) for synchronizing a data flow of the response signal between the DUT (30) and the receiving unit (50), whereby the synchronizing unit (40) receives a first clock signal (DUT-CLK) from the DUT (30) and a second clock signal (CLK) of the testing unit (10), the synchronizing unit (40) comprising:
a buffer (70) for buffering data,
a write unit (80) for writing data from the DUT (30) into the buffer (70), whereby a write access onto the buffer (70) is controlled by the first dock signal (DUT-CLK),
a read unit (90) for reading out data from the buffer (70) to be provided to the receiving unit (50), whereby a read access onto the buffer (70) is controlled by the second dock signal (CLK).

2. The testing unit (10) of claim 1, wherein the buffer (70) comprises a register structure (70) with a plurality of registers (70A-70H).

3. The testing unit (10) of claim 2, further comprising:
a write pointer (100) adapted to be moved between the pluralities of registers (70A-70H) for defining one of the plurality of registers (70A-70H) to receive and buffer data from the DUT (30), and
a read pointer (110) adapted to be moved between the plurality of registers (70A-70H) for defining one of the pluralities of registers (70A-70H) to be read out.

4. The testing unit (10) of claim 3, wherein the write pointer (100) is adapted to be clocked by the first dock signal (DUT-CLK) for successively writing successive data words from the DUT (30) to different registers (70A-70H), and the read pointer (110) is adapted to be clocked by the second clock signal (CLK) for successively reading out successive data words buffered in the plurality of registers (70A-70H).

5. The testing unit (10) of claim 1 or any one of the above claims, wherein the write unit (80) comprises a latch controlled by the first clock signal (DUT-CLK), so that successive data words can be latched with the first clock signal (DUT-CLK) and thus successively written into the buffer (70).

6. The testing unit (10) of claim 1 or any one of the above claims, wherein the buffer (70) is adapted to provide an initial delay time between a first valid write access and a first valid read access.

7. The testing unit (10) of claim 6, wherein the initial delay time is provided dependent on the maximum expected variation between such write and read accesses.

8. A method for testing a device under test - DUT - (30), the method comprising the steps of:
(a) applying a stimulus signal to the DUT (30),
(b) writing data in response to the stimulus signal from the DUT (30) into a buffer (70), whereby a write access onto the buffer (70) is controlled by a first clock signal (DUT-CLK) of the DUT (30),
(c) reading out data from the buffer (70) to be provided to a receiving unit (50), whereby a read access onto the buffer (70) is controlled by a second clock signal (CLK) of the receiving unit (50),
(d) receiving the read out data in response to the stimulus signal by the receiving unit (50).

9. The method of claim 8, further comprising a step of initializing a first valid write access and/or a first valid read access.

## Patentansprüche

1. Eine Testeinheit (10) zum Testen einer zu testenden Vorrichtung - DUT - (30) bestehend aus:
einem Signalgenerator (20) angepaßt zum Senden eines Stimulus-Signals an die DUT (30),
einer Empfangseinheit (50) angepaßt zum Empfang eines Antwortsignals von der DUT auf das empfangene Stimulus-Signal, und
einer Synchronisierungseinheit (40) zur Synchronisierung eines Datenflusses des Antwortsignals zwischen der DUT (30) und der Empfangseinheit (50), wobei die Synchronisierungseinheit (40) ein erstes Takt Signal (DUT-CLK) von der DUT (30) erhält sowie ein zweites Takt Signal (CLK) von der Testeinheit (10); die Synchroniserungseinheit (40) weist auf:
einen Puffer (70) zum Puffern von Daten,
eine Schreibeinheit (80) zum Schreiben von Daten von der DUT (30) in den Puffer (70), wobei ein Schreibzugang zum Puffer (70) kontrolliert wird durch das erste Takt Signal (DUT -CLK),
eine Leseeinheit (90) zum Lesen von Daten aus dem Puffer (70) zur Übermittlung an die Empfangseinheit (50), wobei ein Lesezugang zum Puffer (70) kontrolliert wird durch das zweite Takt Signal (CLK).

2. Die Testeinheit (10) nach Anspruch 1, wobei der Puffer (70) eine Registrierstruktur (70) mit einer Vielzahl von Registern (70A - 70H) umfaßt.

3. Die Testeinheit (10) nach Anspruch 2, zusätzlich versehen mit:
einem Schreibzeiger (100) beweglich zwischen der Vielzahl von Registern (70A-70H) zur Definierung eines aus der Vielzahl von Registern (70A-70H) zum Empfang und Puffern von Daten von der DUT (30), und
einem Lesezeiger (110) beweglich zwischen der Vielzahl von Registern (70A-70H) zur Definierung eines aus der Vielzahl von Registern (70A-70H) aus dem gelesen wird.

4. Die Testeinheit (10) nach Anspruch 3, wobei der Schreibzeiger (100) geeignet ist, durch das erste Takt Signal (DUT-CLK) angesprochen zu werden, um sukzessiv Daten von der DUT (30) in verschiedene Register (70A-70H) zu schreiben, und der Lesezeiger (110) geeignet ist, durch das zweite Takt Signal (DUT-CLK) angesprochen zu werden, um sukzessiv Daten abzulesen, die in der Vielzahl von Registern (70A-70H) gepuffert sind.

5. Die Testeinheit (10) nach Anspruch 1 oder einem der vorstehenden Ansprüche, wobei die Schreibeinheit (80) einen Latch umfaßt, der durch das erste Takt Signal (DUT - CLK) kontrolliert wird, sodass sukzessive Datenworte mit dem ersten Takt Signal gelatcht und somit sukzessive in den Puffer (70) geschrieben werden können.

6. Die Testeinheit (10) nach Anspruch 1 oder einem der vorstehenden Anprüche, wobei der Puffer (70) eine anfängliche Verzögerung zwischen einem ersten gültigen Schreibzugang und einem ersten gültigen Lesezugang ermöglichen kann.

7. Die Testeinheit (10) nach Anspruch 6, wobei die anfängliche Verzögerungszeit vorgesehen wird, die abhängig von der maximal erwarteten Variation zwischen einem solchen Schreib- und Lesevorgang ist.

8. Eine Testmethode zum Testen einer zu testenden Vorrichtung - DUT - (30), wobei die Methode folgende Schritte umfaßt:
a) ein Stimulus-Signal an die DUT (30) zu senden,
b) als Antwort auf das Stimulus-Signal von der DUT (30) Daten in einen Puffer (70) zu schreiben, wobei ein Schreibzugang auf den Puffer (70) kontrolliert wird durch ein erstes Takt Signal (DUT - CLK) der DUT (30),
c) Daten aus dem Puffer (70) abzulesen zur Übermittlung an eine Empfangseinheit (50), wobei ein Lesezugang auf den Puffer (70) kontrolliert wird durch ein zweites Takt Signal (CLK) der Empfangseinheit;
d) die abgelesenen Daten als Antwort auf das Stimulus-Signal von der Empfangseinheit aufzunehmen.

9. Die Methode nach Anspruch 8, umfassend zudem einen Schritt zur Initialisierung eines gültigen ersten Schreibvorgangs und/oder eines ersten gültigen Lesevorgangs.

## Revendications

1. Une unité d'essai (10) servant à tester un appareil mis à l'épreuve - DUT - (30), comprenant :
un générateur de signaux (20) conçu pour envoyer un signal stimulant au DUT (30),
une unité réceptrice (50) conçue pour recevoir une réponse de la part du DUT au signal stimulant envoyé, et
une unité de synchronisation (40) pour synchroniser un flux de données du signal de réponse entre le DUT (30) et l'unité réceptrice (50), dans laquelle l'unité de synchronisation (40) reçoit un premier signal d'horloge (DUT-CLK) du DUT (30) puis un second signal d'horloge (CLK) de l'unité d'essai (10), l'unité de synchronisation comprenant :
un tampon (70) pour stocker provisoirement les données,
une unité d'écriture (80) pour écrire les données du DUT (30) dans la mémoire tampon (70),le droit d'accès en écriture sur la mémoire tampon (70) étant contrôlé par le premier signal d'horloge (DUT-CLK),
une unité de lecture (90) pour lire les données sortant de la mémoire tampon (70) et envoyées dans l'unité réceptrice (50), dans laquelle le droit d'accès en lecture de la mémoire tampon (70) est contrôlé par le second signal d'horloge (CLK).

2. L'unité d'essai (10) de la revendication 1, dont la mémoire tampon (70) comprend une structure de registres (70) avec plusieurs registres (70A-70H).

3. L'unité d'essai (10) de la revendication 2 comprend en plus :
une aiguille d'écriture (100) conçue pour se déplacer entre les différents registres (70A-70H) pour déterminer quel registre (70A-70H) recevra et mémorisera les données du DUT (30), et
une aiguille de lecture (110) conçue pour se déplacer entre les différents registres (70A-70H) pour déterminer quel registre (70A-H) doit être lu.

4. L'unité d'essai (10) de la revendication 3, dont l'aiguille d'écriture (100) est conçue pour être déclenchée par le premier signal d'horloge (DUT-CLK) pour écrire successivement des données successives du DUT (30) dans les différents registres (70A-70H), et dont l'aiguille de lecture (110) est conçue pour être déclenchée par le second signal d'horloge (CLK) pour lire successivement des données successives mémorisées dans les différents registres (70A-70H).

5. L'unité d'essai (10) de la revendication 1 ou une autre parmi les revendications ci-dessus, dont l'unité d'écriture (80) comprend un verrouillage contrôlé par le premier signal d'horloge (DUT-CLK), de façon à ce que les données successives soient verrouillées avec le premier signal d'horloge (DUT-CLK) et donc écrites successivement dans le tampon (70).

6. L'unité d'essai (10) de la revendication 1 ou une autre parmi les revendications ci-dessus, dont la mémoire tampon (70) est conçue pour procurer un délai initial entre le premier droit d'accès en écriture valide et le premier accès en lecture valide.

7. L'unité d'essai (10) de la revendication 6, dont le temps de délai initial est attribué en fonction de la variation maximale attendue entre ces accès en écriture et en lecture.

8. une méthode pour tester un appareil mis à l'épreuve - DUT - (30), cette méthode comprenant les étapes suivantes :
(a) envoyer un signal stimulant au DUT (30),
(b) écrire les données que le DUT (30) envoie en réponse au stimulus vers la mémoire tampon (70) ; un droit accès en écriture sur la mémoire tampon (70) est contrôlé par un premier signal d'horloge (DUT-CLK) provenant du DUT (30),
(c) lire les données de la mémoire tampon (70) à envoyer dans l'unité réceptrice (50), où le droit d'accès en lecture sur la mémoire tampon (70) est contrôlé par un second signal d'horloge (CLK) provenant de l'unité réceptrice (50),
(d) recevoir les données lues dans l'unité réceptrice (50) en réponse au signa! stimulant.

9. La méthode de la revendication 8, comprenant une étape supplémentaire d'initialisation d'un premier accès en écriture et/ou en lecture valide.
